# EUROPEAN PATENT SPECIFICATION

(11) **EP 2 541 608 B1**
(45) Date of publication and mention of the grant of the patent: **21.12.2016**
(21) Application number: 12174509.5
(22) Date of filing: 29.06.2012
(51) Int. Cl.: H01L 29/78, H01L 21/336, H01L 29/40

(54) **High breakdown voltage semiconductor device with an insulated gate formed in a trench, and manufacturing process thereof**
Halbleitervorrichtung mit hoher Durchbruchspannung und mit isoliertem in einem Graben geformten Gate sowie Herstellungsverfahren dafür
Dispositif semi-conducteur à haute tension de claquage avec une grille isolée formée dans une tranchée et son procédé de fabrication

(30) Priority: 29.06.2011 IT TO20110571
(43) Date of publication of application: 02.01.2013
(60) Divisional application: 13193878.9
(73) Proprietor: STMicroelectronics S.r.l., Agrate Brianza (IT)
(72) Inventor: Barletta, Giacomo, 95024 Acireale (IT)
(74) Representative: Cerbaro, Elena

(56) References cited:
- DE-A1- 10 234 996
- DE-A1- 10 341 592
- US-A1- 2006 289 929
- US-A1- 2007 032 020
- US-A1- 2008 214 004

## Description

The present invention relates to an insulated-gate semiconductor device and to the manufacturing process thereof. More specifically, the invention regards a metal-oxide-semiconductor (MOS) device of the type comprising a trench used for insulation of the gate region of the device, also known as "semiconductor device with an insulated gate formed in a trench", or else "MOS device of a trench-gate type".

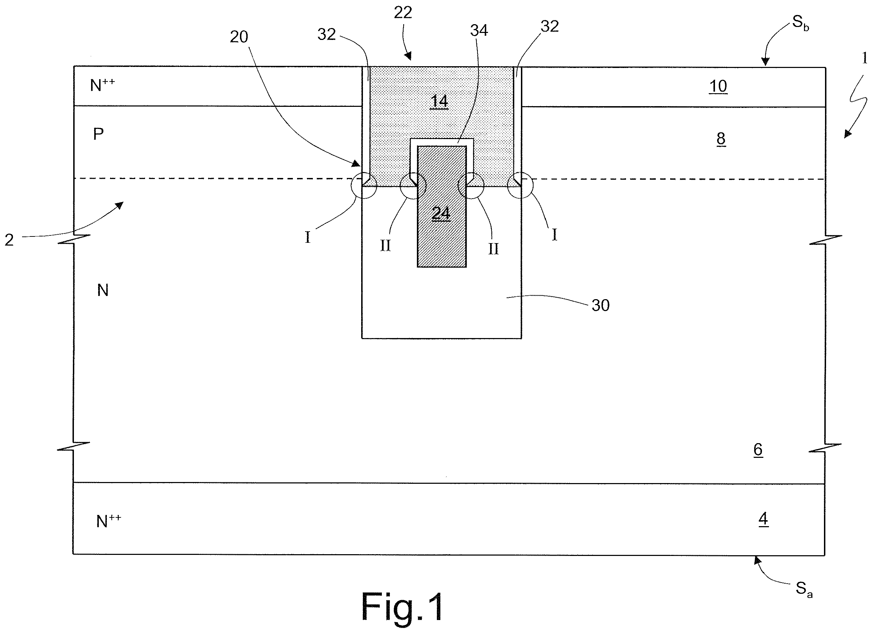

By way of example, Figure 1 shows a MOS device of a trench-gate type 1 known to the art, which is a vertical-conduction field-effect device.

In detail, the MOS device of a trench-gate type 1, referred to hereinafter as "MOS device 1", comprises a body 2 of semiconductor material, which is formed by: a substrate 4; a drift region 6, provided on top of the substrate 4, with which it is in direct contact; a body region 8, provided on top of the drift region 6, with which it is in direct contact; and a source region 10, provided on top of the body region 8, with which it is in direct contact.

In greater detail, the substrate 4, the drift region 6 and the source region 10 have one and the same type of conductivity, referred to hereinafter as the "first type of conductivity". The body region 8 may also have the first type of conductivity, or else may have a conductivity of an opposite type, according to the configuration of the MOS device 1. For instance, in the case where, as illustrated in Figure 1, the MOS device 1 is of the enhancement type, the body region 8 has a conductivity of an opposite type with respect to the conductivity of the substrate 4 of the drift region 6 and of the source region 10. By way of example, the substrate 4, the drift region 6, and the source region 10 have a conductivity of an N type, whilst the body region 8 has conductivity of a P type.

As regards, instead, the doping levels, the substrate 4 and the source region 10 have doping levels that are generally comparable with, and higher than the doping level of the drift region 6.

Given this, the substrate 4 and the drift region 6 function as drain region in such a way that the body region 8 is arranged between the source region 10 and the drain region.

The drain and source terminals (not shown) of the MOS device 1 are arranged, respectively, underneath a bottom (with reference to the orientation of the MOS device 1 shown in Figure 1) surface Sₐ of the body 2 and on top of a top (with reference to the orientation of the MOS device 1 shown in Figure 1) surface S_{b} of the body 2 in such a way as to reduce the lateral dimensions of the MOS device 1.

The MOS device 1 further comprises a gate region 14, arranged in the proximity of the body region 8, from which it is separated by an insulating structure 20 of dielectric material. In general, the gate region 14 may be made of metal material, or else semiconductor material such as, for example, heavily doped polycrystalline silicon.

The gate region 14 is at least partially buried; i.e., it is formed at least in part within a trench 22 formed in the body 2, starting from the top surface S_{b}. Furthermore, the gate region 14 is electrically insulated from the body 2, by means of the aforementioned insulating structure 20, which extends within the trench 22 so as to surround the gate region 14 laterally and at the bottom.

The MOS device 1 further comprises an additional region 24, made of metal material or semiconductor material such as, for example, polycrystalline silicon. In detail, the additional region 24, generally known as field region or as conductive region, is arranged underneath the gate region 14 and is electrically insulated from the latter. In even greater detail, the conductive region 24 is arranged within the trench 22 and extends vertically between a first depth and a second depth (measured, for example, with respect to the top surface S_{b}), the first and second depths being, respectively, smaller and greater than the maximum depth of the gate region 14, the latter depth being at least equal to the maximum depth of the body region 8. Consequently, a top portion of the conductive region 24 is surrounded laterally and at the top by the gate region 14.

For the purpose of insulating the gate region 14 and the conductive region 24, the insulating structure 20 comprises an insulating region 30, a gate insulating layer 32, and a further insulating layer 34, referred to hereinafter as "field insulating layer 34".

The insulating region 30 is made of dielectric material and extends along bottom portions of the side walls of the trench 22, as well as on the bottom of the trench 22, in such a way as to surround a bottom portion of the conductive region 24 at the bottom and laterally.

The gate insulating layer 32, which is also made of dielectric material, extends along top portions of the side walls of the trench 22, on top of the insulating region 30, to which it is connected, and laterally with respect to the gate region 14, with which it is in direct contact, in such a way as to insulate the gate region 14 from the source region 10 and the body region 8. Furthermore, the gate insulating layer 32 has a smaller thickness than the insulating region 30. The gate insulating layer 32 forms the gate oxide of the MOS device 1. Consequently, the thickness of the gate insulating layer 32 determines the threshold voltage of the MOS device 1.

The field insulating layer 34 performs the function of separating the gate region 14 and the conductive region 24, between which it is arranged, electrically from one another.

In detail, the field insulating layer 34 is in direct contact with the gate region 14 and extends on top of the conductive region 24, with which it is in direct contact. In addition, the field insulating layer 34 extends vertically so as to surround the top portion of the conductive region 24 laterally until it comes into contact with the insulating region 30. The conductive region 24 is hence surrounded in part by the insulating region 30 and in part by the field insulating layer 34.

Operatively, by applying an appropriate control voltage to the gate region 14, it is possible to form a conductive channel within the body region 8, and in particular within a subregion of the body region 8, which is arranged in contact with the gate insulating layer 32 and is known as "channel region". This conductive channel is formed in the proximity of the side walls of the trench 22.

In order to improve the dynamic performance of the MOS device 1, it is necessary to limit the parasitic capacitance present between the gate region 14 and the drain terminal, at the same time guaranteeing a sufficient capacitive coupling between the gate region 14 and the body region 8 in order to enable control of the conductivity of the body region 8 by means of application of a control voltage to the gate region 14.

The conductive region 24 performs, precisely, the function of shielding the gate region 14 from the body 2, and in particular from the drain region. For this purpose, the conductive region 24 can be connected electrically to the source region 10 in such a way as to supply a very precise potential in the proximity of the gate region 14, thus converting part of the drain-gate capacitance into an additional drain-source capacitance.

Given this, in order to reduce the number of process steps necessary for manufacturing the MOS device 1, generally the gate insulating layer 32 and the field insulating layer 34 are formed in the course of one and the same oxidation process. However, this manufacturing technique requires that the thicknesses of the gate insulating layer 32 and of the field insulating layer 34 are comparable, which may cause malfunctioning of the MOS device 1, and in particular may cause the MOS device 1 to have a breakdown voltage, i.e., a maximum insulation voltage of the gate region 14, that is limited. It is in fact known that, by so doing, the gate-oxide layer 32 has a thinned portion at the points of contact I with the insulating region 30. Likewise, the field-oxide layer 34 also has a thinned portion at the points of contact II with the insulating region 30.

In use, these thinned portions are subject to voltages of the order of some tens of volts since the points of contact I and II participate in insulation of the gate region 14. Consequently, at these thinned portions it is possible for the phenomenon of the premature breakdown of the dielectric to take place.

In order to optimize operation of the MOS device 1, and in particular in order to guarantee that the breakdown voltage between the gate region 14 and the conductive region 24 is approximately equal to the breakdown voltage between the gate region 14 and the source region 10, techniques have been developed that enable increase of the thickness of the field insulating layer 34 with respect to the thickness of the gate insulating layer 32.

For instance, the patent No. US 7,005,351 describes a technique based upon the use of a mixture of gases formed by oxygen and hydrogen, which enables acceleration of the rate of oxidation in the proximity of a heavily doped surface such as the surface of the conductive region 24. In this way, it is possible for the field insulating layer 34 to have a thickness at least 5% greater than the thickness of the gate insulating layer 32.

The Italian patent application No. VI2010A000336, filed on December 14, 2010 in the name of the present applicant, describes, instead, a technique that envisages increase of a rate of oxidation of at least one portion of a surface of the conductive region 24. In order to increase the rate of oxidation, the conductive region 24 is doped with arsenic. In particular, the conductive region 24 is doped alternatively *in situ* or else by means of subsequent ion implantation. As a further alternative, the technique described envisages forming at least part of the conductive region 24 of an alloy of semiconductor material and germanium.

US 2006/0289929 discloses a process of manufacturing a field effect transistor, which includes forming an oxidation barrier layer over a surface of a silicon region adjacent a trench and along the trench sidewalls and bottom. A protective layer is formed over the oxidation barrier layer inside and outside the trench. The protective layer is then partially removed such that a portion of the oxidation barrier layer extending along the trench bottom becomes exposed and portions of the oxidation barrier layer extending over the surface of the silicon region adjacent the trench remain covered by the protective layer.

US 2007/0032020 discloses a process including the steps of forming a trench in a semiconductor region, forming a dielectric layer filled with a conductive material and lining the trench sidewalls and bottom. The conductive material is recessed into the trench to form a shield electrode; the recessing includes isotropic etching of the conductive material.

US 2008/0214004 discloses a process including the steps of providing a semiconductor substrate with an active region and a margin region bordering on the active region. The spacer layer in the margin region is broken through at a selected location and at least part of the spacer layer is removed in the active region using a common process. The location is selected such that at least part of the semiconductor mesa structure is exposed and the spacer layer in the margin region is broken through to the conductive layer and not to the semiconductor substrate.

DE 10234996 discloses a process including the steps of: forming a trench in a process layer of a semiconductor substrate; forming a field electrode and a gate electrode separately from each other and electrically insulated by the process layer; forming a drift zone, a channel zone and a source zone in the process zone. Either the source zone or the channel zone is produced after the trench is formed in the semiconductor substrate.

DE 10341592 discloses a gate electrode which is arranged between a semiconductor cell height and a semiconductor cell surface, and has a lower edge with obliquely angled profile. The gate electrode and the field electrode are insulated by insulating layers.

In general, the techniques proposed effectively enable increase of the thickness of the field insulating layer 34 as compared to the thickness of the gate insulating layer 32, and hence at least partial compensation of the reduction of the breakdown voltage due to the aforementioned thinned portions, in particular to the thinned portions in the points of contact II.

The aim of the present invention is to provide a semiconductor power device with an insulated gate formed in a trench and a manufacturing process that will enable a further increase in the breakdown voltage to be obtained.

According to the present invention, a semiconductor device with an insulated gate formed in a trench and a manufacturing process are provided as defined in claim 1 and claim 2, 5, respectively.

For a better understanding of the present invention, embodiments thereof are now described, purely by way of nonlimiting example, with reference to the attached drawings, wherein:
- Figure 1 is a schematic illustration of a cross section of a semiconductor device with an insulated gate formed in a trench, according to the known art;
- Figure 2 is a schematic illustration of a cross section of the present semiconductor device with an insulated gate formed in a trench; and
- Figures 3-15 are schematic illustrations of sections of the present semiconductor device with an insulated gate formed in a trench, during successive manufacturing steps.

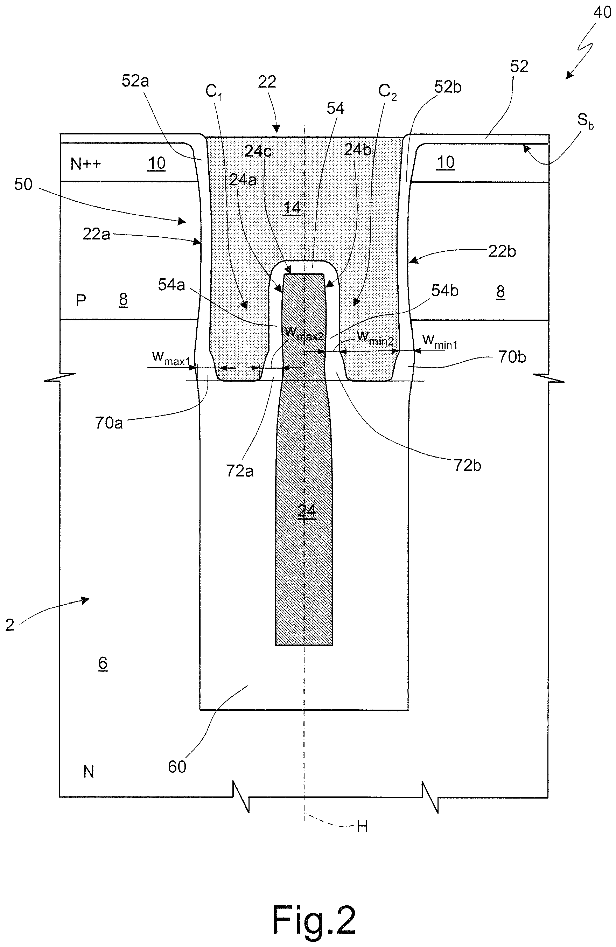

Figure 2 shows a portion of a semiconductor device with an insulated gate formed in a trench, designated by 40, referred to hereinafter, for reasons of brevity, as "semiconductor device 40". The ensuing treatment refers only to the portion shown in Figure 2, which is useful for an understanding of the invention, even though the semiconductor device 40 comprises further elements, in themselves known. Furthermore, elements that are already present in the MOS device 1 are designated by the same references, except where otherwise specified. In the sequel of the present description, recourse is moreover had to the terms "top" and "bottom", which refer to the orientation assumed by the semiconductor device 40 in Figure 2.

In detail, the semiconductor device 40 comprises the body 2 of semiconductor material, formed inside which are, on top of the substrate (not shown), the source region 10, the body region 8, and the drift region 6. Furthermore, the trench 22 extends within the body 2; in particular, the trench 22 extends from the top surface S_{b} of the body 2.

Present within the trench 22 are the insulating structure (here designated by 50), the gate region 14, and the conductive region 24, the latter being arranged underneath the gate region 14. The gate region 14 and the conductive region 24 are made of semiconductor material (alternatively intrinsic or doped), such as for example polycrystalline silicon.

In detail, the conductive region 24 is arranged within the trench 22 and extends vertically between a first depth and a second depth (measured, for example, with respect to the top surface S_{b}), the first and second depths being, respectively, smaller and greater than the maximum depth of the gate region 14. Consequently, a top portion of the conductive region 24 is surrounded at the top and laterally by the gate region 14.

The insulating structure 50 includes the gate insulating layer, here designated by 52, the field insulating layer, here designated by 54, and the insulating region, here designated by 60.

The insulating region 60 is made of dielectric material and extends along bottom portions of the side walls of the trench 22, as well as on the bottom of the trench 22 in such a way as to surround a bottom portion of the conductive region 24 at the bottom and laterally.

The gate insulating layer 52, which is also made of dielectric material, extends over the top surface S_{b} of the body 2, as well as along top portions of the side walls of the trench 22, on top of the insulating region 60 and laterally with respect to the gate region 14, with which it is in direct contact, in such a way as to insulate the gate region 14 from the source region 10 and from the body region 8.

The field insulating layer 54 is arranged between the gate region 14 and the conductive region 24 in such a way as to insulate the top portion of the conductive region 24 electrically from the gate region 14.

In practice, the conductive region 24 extends in part within the gate region 14 and in part within the insulating region 60 in such a way that it defines a first cavity C₁ and a second cavity C₂ within the trench 22, both occupied by the gate region 14. The field insulating layer 54 is in direct contact with the gate region 14 and extends on top of the conductive region 24, with which it is in direct contact. In addition, the field insulating layer 54 extends vertically so as to surround the top portion of the conductive region 24 laterally.

In greater detail, the trench 22 has a first side wall 22a and a second side wall 22b; moreover, the conductive region 24 has a first side wall 24a and a second side wall 24b, as well as a top wall 24c. The first and second side walls 24a, 24b of the conductive region 24 face, respectively, the first and second side walls 22a, 22b of the trench 22.

In greater detail still, the first and second side walls 22a, 22b of the trench 22 and the first and second side walls 24a, 24b of the conductive region 24 are undulated. In particular, the first and second side walls 22a, 22b of the trench 22 are undulated in such a way that the distance (the lateral distance, i.e., the distance measured in a direction parallel to the top surface S_{b} of the body 2) between them, i.e., the width of the trench 22, depends upon the depth.

In detail, the distance between the first and second side walls 22a, 22b of the trench 22 assumes a first value at the top surface S_{b} (for example, equal to 2.2 µm), then decreases as the depth increases until it assumes a first relative minimum, approximately at the first depth of the conductive region 24. Next, this distance increases again, until it assumes a relative maximum at a depth equal at the most to the maximum depth of the gate region 14 (for example, comprised between 1.5 µm and 2 µm). Then the distance decreases monotonically as far as the bottom of the trench 22.

In practice, the distance between the first and second side walls 22a, 22b of the trench 22 varies in a non-monotonic way with the depth, with a maximum variation for example equal to 0.1 µm. Furthermore, the profiles with the depth of the first and second side walls 22a, 22b of the trench 22 are to a first approximation specular with respect to an axis of symmetry H of the trench 22.

As regards, instead, the first and second side walls 24a, 24b of the conductive region 24, they are undulated in such a way that the width of the conductive region 24 increases, starting from the top wall 24c, until it exhibits a relative maximum, at a depth comprised between the first depth of the conductive region 24 and the maximum depth of the gate region 14. Next, the undulation of the first and second side walls 24a, 24b of the conductive region 24 is such that the width of the conductive region 24 assumes a minimum (not necessarily relative) at a depth not greater than the maximum depth of the gate region 14, and then increases monotonically as far as the end of the conductive region 24.

In practice, the distance between the first and second side walls 24a, 24b of the conductive region 24, i.e., the width of the conductive region 24, varies in a non-monotonic way with the depth, with a maximum variation for example equal to 0.1 µm. Furthermore, the profiles with the depth of the first and second side walls 24a, 24b of the conductive region 24 are to a first approximation specular with respect to the axis of symmetry H of the trench 22.

The gate insulating layer 52 comprises a first portion 52a and a second portion 52b, which coat, respectively, the top portions of the first and second side walls 22a, 22b of the trench 22.

In turn, the field insulating layer 54 comprises a first portion 54a and a second portion 54b, which coat, respectively, the top portions of the first and second side walls 24a, 24b of the conductive region 24.

The first and second portions 52a, 52b of the gate insulating layer 52, as likewise the first and second portions 54a, 54b of the field insulating layer 54, are connected to the insulating region 60.

In particular, the first and second portions 52a, 52b of the gate insulating layer 52 are connected to the insulating region 60 by interposition, respectively, of a first gate-connecting thickened portion 70a and a second gate-connecting thickened portion 70b, which are in direct contact with the insulating region 60 and, respectively, with the first and second portions 52a, 52b of the gate insulating layer 52.

In cross section, the first and second gate-connecting thickened portions 70a, 70b have the shape, to a first approximation (i.e., neglecting the undulation of the side walls of the trench and the curvature of the gate-connecting thickened portions themselves), of right trapezia, arranged specular with respect to the conductive region 24.

In detail, the first and second gate-connecting thickened portions 70a, 70b have a thickness that increases as the depth increases, i.e., as the distance increases from the top surface S_{b}. In particular, each between the first and second gate-connecting thickened portions 70a, 70b has a thickness comprised between a minimum thickness wₘᵢₙ₁, approximately equal to the thickness of the gate insulating layer 52, and a maximum thickness wₘₐₓ₁, which is equal at the most to half the distance that separates the first side wall 22a of the trench 22 from the first side wall 24a of the conductive region 24, the latter distance being approximately equal to the distance that separates the second side wall 22b of the trench 22 from the second side wall 24b of the conductive region 24.

In other words, at the first and second gate-connecting thickened portions 70a, 70b, the gate insulating layer 52 assumes a bird's beak shape.

Likewise, the first and second portions 54a, 54b of the field insulating layer 54 are connected to the insulating region 60 by interposition of respective first and second field-connecting thickened portions 72a, 72b, which are in direct contact with the insulating region 60 and, respectively, with the first and second portions 54a, 54b of the field insulating layer 54.

In cross section, the first and second field-connecting thickened portions 72a, 72b have the shape, to a first approximation (neglecting the undulation of the side walls of the conductive region and the curvature of the field-connecting thickened portions themselves), of right trapezia, arranged specular with respect to the conductive region 24.

In detail, both the first field-connecting thickened portion 72a and the second field-connecting thickened portion 72b have a thickness that increases as the depth increases, i.e., as the distance from the top surface S_{b} increases. In particular, each between the first and second field-connecting thickened portions 72a, 72b has a thickness comprised between a minimum thickness xₘᵢₙ₂, approximately equal to the thickness of the field insulating layer 54, and a maximum thickness wₘₐₓ₂, approximately equal to the aforementioned maximum thickness wₘₐₓ₁.

In other words, at the first and second field-connecting thickened portions 72a, 72b, the field insulating layer 54 assumes a bird's beak shape.

The semiconductor device 40 hence does not have the typical thinned portions of the gate insulating layer and of the field insulating layer in the points of contact with the insulating region; consequently, it is characterized by a high breakdown voltage. It is hence possible to apply particularly high voltages between the gate region 14 and the source region 10, the latter moreover being connected to the conductive region 24.

Thanks to the undulations of the first and second side walls 22a, 22b of the trench 22, as well as to the undulations of the first and second side walls 24a, 24b of the conductive region 24, the concentration of the field lines at the points of contact between the insulating region 60 and, respectively, the gate insulating layer 52 and the field insulating layer 54 is moreover limited, with consequent further increase in the breakdown voltage.

In order to manufacture the semiconductor device 40, it is possible to carry out the operations described hereinafter, which initially envisage providing the body 2 of semiconductor material.

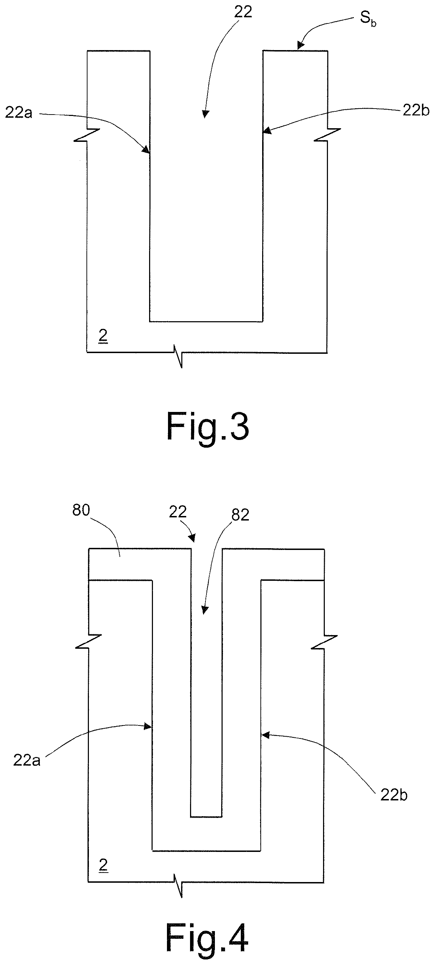

Next (Figure 3), in a way in itself known the trench 22 is formed starting from the top surface S_{b}. The trench 22 may have a width comprised, for example, between 1 µm and 3 µm and may be formed by means of an anisotropic etch, for example of the RIE (reactive ion etching) type, after prior formation of a first dielectric layer (not shown) on the top surface S_{b}, this first dielectric layer being shaped so as to define a trench mask useful for etching the underlying body 2. After formation of the trench 22, the trench mask is removed.

Next (Figure 4), a thick insulating layer 80 is formed, for example by thermal oxidation or else by means of TEOS (tetraethylorthosilicate) oxide deposition. The thickness of the thick insulating layer 80 may be, for example, of between 100 nm and 800 nm; moreover, the trench 22 and the thick insulating layer 80 are such that the thick insulating layer 80 coats the first and second side walls 22a, 22b and the bottom of the trench 22, but does not fill it completely; rather, it defines a portion of free space 82 within the trench 22.

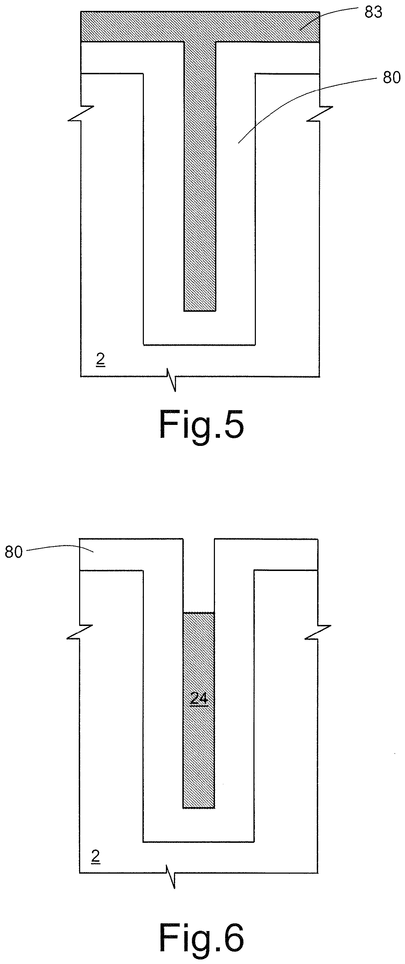

Next (Figure 5), formed on top of the thick oxide layer 80 is a first conductive layer 83, made for example of doped or intrinsic polysilicon. For instance, the first conductive layer 83 may be formed by means of LPCVD (low-pressure chemical vapour deposition).

A selective removal (Figure 6) of portions of the first conductive layer 83 is then carried out in such a way as to form the conductive region 24. For instance, the removal may occur by etching the first conductive layer 83 by means of dry etching.

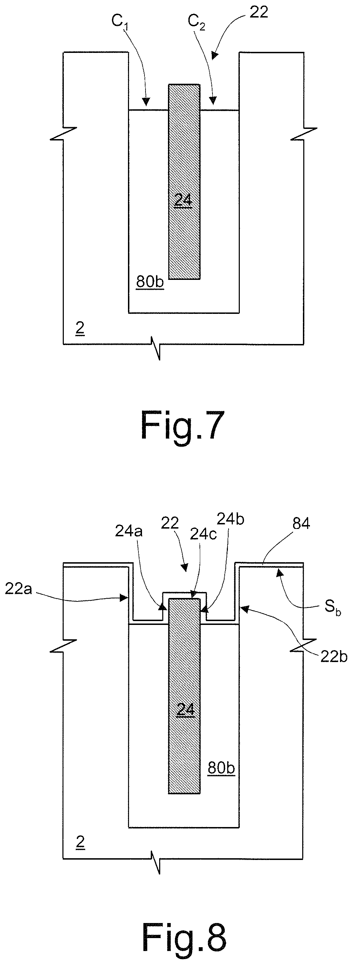

Next (Figure 7), portions of the thick insulating layer 80 are selectively removed, for example by a wet etch so as to form a residual part 80b of the thick insulating layer 80. The removal is such that the top portion of the conductive region 24 extends partially on top of the residual part 80b. In this way, the trench 22 and the conductive region 24 define the first and second cavities C₁, C₂.

Next (Figure 8), a service layer 84, made of dielectric material, such as for example oxide, is formed. For instance, the service layer 84 may be formed by thermal growth. In detail, the service layer 84 extends on the top surface S_{b}. Furthermore, in addition to coating the top wall 24c and the top portions of the first and second side walls 24a, 24b of the conductive region 24, the service layer 84 coats at the top the residual part 80b (i.e., the bottom of the first and second cavities C₁, C₂), as well as the top portions of the first and second side walls 22a, 22b of the trench 22.

In general, the service layer 84 has a different thickness according to the material on which it is formed. In particular, the portions of the service layer 84 that coat the side walls of the trench 22 have a smaller thickness than the portions of the service layer 84 that coat the conductive region 24, since the growth of the service layer 84 is faster on the conductive region 24 (which is polycrystalline) than on the side walls of the trench 22.

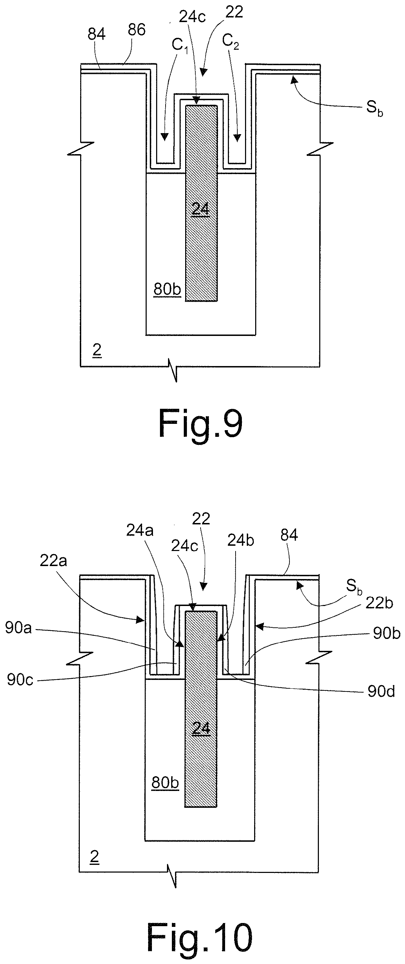

Next (Figure 9), formed on top of the service layer 84, for example by deposition, is a non-oxidizing layer 86, made for example of silicon nitride.

A dry anisotropic etch of the non-oxidizing layer 86 is then made (Figure 10) in order to remove selectively the portions of the non-oxidizing layer 86 parallel to the top surface S_{b}. Then the portions of the non-oxidizing layer 86 arranged on the top surface S_{b} and on the top wall 24c of the conductive region 24 are removed, as well as the portions of the non-oxidizing layer 86 that coat the bottom of the first and second cavities C₁, C₂. In this way, a first spacer, a second spacer, a third spacer, and a fourth spacer 90a-90d are defined.

In detail, the first and second spacers 90a, 90b are arranged vertically and coat, respectively, the portions of the service layer 84 that coat the top portions of the first and second side walls 22a, 22b of the trench 22. The third and fourth spacers 90c, 90d are arranged vertically and coat, respectively, the portions of the service layer 84 that coat the top portions of the first and second side walls 24a, 24b of the conductive region 24.

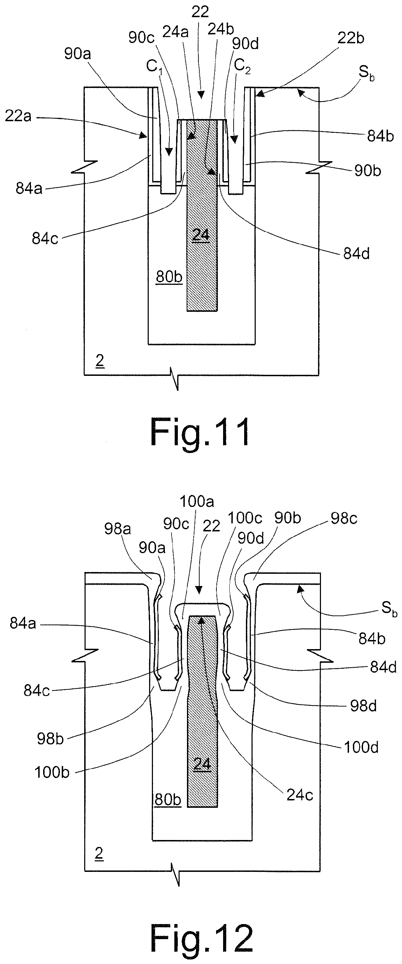

Next (Figure 11), portions of the service layer 84 are selectively removed, for example by means of a dry anisotropic etch. In particular, the portions of the service layer 84 arranged on the top surface S_{b} are removed, as well as the portions of the service layer 84 that coat the bottom of the first and second cavities C₁, C₂.

In greater detail, anisotropic etching is preferably carried out in such a way as to remove not only the portions of the service layer 84 arranged on the bottom of the first and second cavities C₁, C₂ and not overlaid by any one from among the first, second, third, and fourth spacers 90a-90d, but also portions of the residual part 80b of the thick insulating layer 80. In particular, top portions of the residual part 80b, arranged underneath the service layer 84, are removed. In other words, an overetching of the residual part 80b of the thick insulating layer 80 is carried out.

In practice, a first remaining portion 84a, a second remaining portion 84b, a third remaining portion 84c, and a fourth remaining portion 84d of the service layer 84 are thus defined, which in cross section are approximately L-shaped.

More in particular, the first and second remaining portions 84a, 84b are arranged specular with respect to the conductive region 24 and coat, respectively, the top portions of the first and second side walls 22a, 22b of the trench 22; they are hence arranged between the body 2 and, respectively, the first and second spacers 90a, 90b.

The third and fourth remaining portions 84c, 84d are arranged specular with respect to the conductive region 24 and coat, respectively, the top portions of the first and second side walls 24a, 24b of the conductive region 24; they are hence set between the conductive region 24 and, respectively, the third and fourth spacers 90c, 90d.

Next (Figure 12), a thermal treatment is performed at a temperature comprised between 800°C and 1100°C, following upon which:
- the first remaining portion 84a of the service layer 84 forms a first outer thickened portion 98a and a second outer thickened portion 98b, arranged, respectively, in the uppermost point of the first remaining portion 84a (on the top surface S_{b}) and in contact with the residual part 80b of the thick insulating layer 80;
- the second remaining portion 84b of the service layer 84 forms a third outer thickened portion 98c and a fourth outer thickened portion 98d, arranged, respectively, in the uppermost point of the second remaining portion 84b (on the top surface S_{b}) and in contact with the residual part 80b of the thick insulating layer 80;

- the third remaining portion 84c of the service layer 84 forms a first inner thickened portion 100a and a second inner thickened portion 100b, arranged, respectively, in the uppermost point of the third remaining portion 84c (on the top wall 24c) and in contact with the residual part 80b of the thick insulating layer 80; and
- the fourth remaining portion 84d of the service layer 84 forms a third inner thickened portion 100c and a fourth inner thickened portion 100d, arranged, respectively, in the uppermost point of the fourth remaining portion 84d (on the top wall 24c) and in contact with the residual part 80b of the thick insulating layer 80.

In practice, the second and fourth outer thickened portions 98b, 98d represent initial thickened portions designed to form, respectively, the first and second gate-connecting thickened portions 70a, 70b. Likewise, the second and fourth inner thickened portions 100b, 100d represent initial thickened portions designed to form, respectively, the first and second field-connecting thickened portions 72a, 72b.

During this thermal oxidation process, it moreover occurs that the first and second side walls 22a, 22b of the trench 22 and the first and second side walls 24a, 24b of the conductive region 24 assume the undulated profiles described previously.

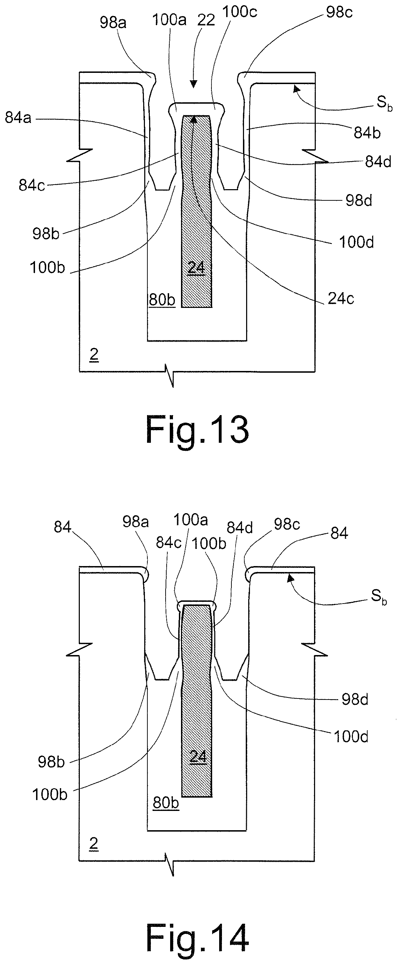

Next (Figure 13), the first, second, third, and fourth spacers 90a-90d are removed, for example by means of a solution of phosphoric acid (H₃PO₄).

Next (Figure 14), the first and second remaining portions 84a, 84b of the service layer 84 are removed, for example by controlled isotropic etching in hydrogen fluoride HF, and simultaneously the thickness of the portions of the service layer other than the first and second remaining portions 84a, 84b decreases. This reduction of thickness consequently involves, at least partially, the first and third outer thickened portions 98a, 98c and the first and third inner thickened portions 100a, 100c, as well as the portion of service layer 84 arranged on top of the conductive region 24. Marginally, also the second and fourth outer thickened portions 98b, 98d and the second and fourth inner thickened portions 100b, 100d may be involved in the reduction of thickness.

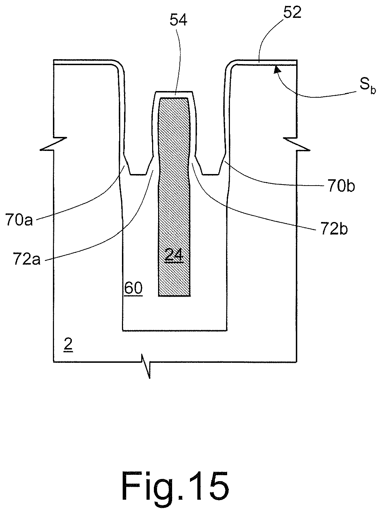

Next (Figure 15), the gate insulating layer 52 and the field insulating layer 54 are formed, for example by means of thermal oxidation. In practice, the gate insulating layer 52 and the field insulating layer 54 are formed simultaneously, during one and the same technological step, and are portions of one and the same layer. Furthermore, during the operation of formation of the gate insulating layer 52 and of the field insulating layer 54, the second and fourth outer thickened portions 98b, 98d form, respectively, the first and second gate-connecting thickened portions 70a, 70b; moreover, the second and fourth inner thickened portions 100b, 100d form, respectively, the first and second field-connecting thickened portions 72a, 72b. Simultaneously, the residual part 80b of the thick insulating layer 80 forms the insulating region 60.

In a way in itself known (not shown), the gate region 14 is then formed. Next, in a way in itself known, the body region 8 and the source region 10 are formed, for example by ion implantation and subsequent activation of the dopant.

The advantages that the present semiconductor device 40 emerge clearly from the foregoing description. In particular, it is characterized by the presence of thickened regions at the points of contact between the gate insulating layer and field insulating layer and the insulating region, and consequently has a high breakdown voltage between the gate region 14 and the source region 10, as well as between the conductive region 24 and the drift region 6. Furthermore, also the curvature of the side walls of the trench in the proximity of the points of contact between the gate insulating layer and the insulating region, as well as the curvature of the side walls of the conductive region in the proximity of the points of contact between the field insulating layer and the insulating region, concur to increase the breakdown voltage of the semiconductor device 40.

Finally, it is evident that modifications and variations may be made to the semiconductor device 40 and to the manufacturing process thereof, without thereby departing from the scope of the present invention.

For instance, instead of the service layer 84 a multilayer structure including at least one sacrificial oxide, obtained by thermal growth, may be formed, and a dielectric layer obtained by TEOS-oxide deposition may be formed on top of the sacrificial layer.

Likewise, in forming the service layer it is possible carry out a TEOS-oxide deposition, possibly instead of the thermal growth.

## Claims

1. A vertical semiconductor device, comprising:
- a semiconductor body (2) having a top surface (S_{b});
- a trench (22) formed in the semiconductor body starting from the top surface and having side walls (22a, 22b) and a bottom;
- a gate region (14) of conductive material, extending within the trench;
- an insulating region (60) extending along bottom portions of the side walls of the trench and on the bottom of the trench;
- a gate insulating layer (52) extending along top portions of the side walls of the trench on top of the insulating region and laterally with respect to the gate region;
- a conductive region (24) extending within the trench, a top portion of the conductive region being surrounded at the top and laterally by the gate region, a bottom portion of the conductive region being surrounded at the bottom and laterally by the insulating region; and
- a field insulating layer (54) arranged between the gate region and the conductive region so as to electrically separate the gate region and the conductive region from one another;
**characterized in that** the field insulating layer is connected to the insulating region by means of field-connecting thickened portions (72a, 72b), each of which has a thickness that increases as the depth increases; and wherein the gate insulating layer (52) is connected to the insulating region (60) by means of gate-connecting thickened portions (70a, 70b), each of which has a thickness that increases as the depth increases; and wherein the side walls (22a, 22b) of the trench (22) are undulated in such a way that the width of the trench varies in a non-monotonic way with the depth, thereby assuming a first value at the top surface (S_{b}), then decreasing as the depth increases until a first relative minimum is assumed, then increasing again, until assuming a relative maximum at a depth equal at the most to the maximum depth of the gate region (14), then decreasing monotonically as far as the bottom of the trench; and wherein the conductive region (24) has corresponding side walls (24a, 24b), which are undulated, in such a way that the width of the conductive region varies in a non-monotonic way with the depth, thereby increasing, starting from a top wall (24c) of the conductive region (24), until exhibiting a relative maximum, at a depth comprised between the depth of the top wall (24c) of the conductive region (24) and the maximum depth of the gate region (14), then decreasing until assuming a minimum at a depth not greater than the maximum depth of the gate region (14), and then increasing monotonically as far as the bottom of the conductive region (24).

2. A process for manufacturing a vertical semiconductor device, comprising the steps of:
- forming a semiconductor body (2) having a top surface (S_{b});
- forming, in the semiconductor body, a trench (22) having side walls and a bottom and extending from the top surface;
- forming, within the trench, a gate region (14) of conductive material;
- forming, along bottom portions of the side walls of the trench and on the bottom of the trench, an insulating region (60), said step of forming an insulating region (60) comprising forming a thick insulating layer (80b) within the trench (22);
- forming, along top portions of the side walls of the trench, a gate insulating layer (52), a gate insulating layer extending on top of the insulating region and laterally with respect to the gate region;
- forming, within the trench, a conductive region (24) having side walls (24a, 24b), a top portion of the conductive region being surrounded at the top and laterally by the gate region, a bottom portion of the conductive region being surrounded at the bottom and laterally by the insulating region, said step of forming a conductive region (24) comprising forming the conductive region in such a way that it extends in part on top of the thick insulating layer, defining a first cavity (C₁) and a second cavity (C₂) within the trench, the bottoms of said cavities being delimited by the thick insulating layer; and
- forming, between the gate region and the conductive region, a field insulating layer (54) that electrically separates the gate region and the conductive region from one another;
**characterized in that** it further comprises the steps of:
- connecting the field insulating layer (54) to the insulating region (60) by means of field-connecting thickened portions (72a, 72b), each of which has a thickness that increases as the depth increases;
- connecting the gate insulating layer (52) to the insulating region by means of gate-connecting thickened portions (70a, 70b), each of which has a thickness that increases as the depth increases;
said process further comprising the steps of:
- coating with a service layer (84) of dielectric material the top portions of the side walls (22a, 22b) of the trench (22), the top portions of the side walls of the conductive region and the bottoms of the first and second cavities (C₁, C₂);
- forming, on the portions of the service layer that coat the top portions of the side walls of the trench and the top portions of the side walls of the conductive region, corresponding spacers (90a-90d) of non-oxidizing material; and
- selectively removing portions of the service layer arranged on the bottoms of the first and second cavities so as to define a first pair (84a-84b) and a second pair (84c-84d) of remaining service-layer portions, said first and second pairs of remaining service-layer portions coating, respectively, the top portions of the side walls of the trench and the top portions of the side walls of the conductive region;
and wherein the steps of connecting the gate insulating layer (52) and the field insulating layer (54) to the insulating region (60) comprise carrying out, after formation of the spacers and after selective removal of portions of the service layer arranged on the bottoms of the first and second cavities, a first thermal treatment, in such a way that the first and second pairs of remaining service-layer portions form, respectively, a first pair (98b-98d) and a second pair (100b-100d) of initial thickened portions on the bottoms of the first and second cavities;
said process further comprising the steps of:
- removing the spacers (90a-90d); and then
- removing said first pair (84a-84b) of remaining service-layer portions and simultaneously reducing the thickness of said second pair (84c-84d) of remaining service-layer portions;
and wherein the step of forming a gate insulating layer (52), the step of forming a field insulating layer (54) and the steps of connecting the gate insulating layer and the field insulating layer to the insulating region (60) comprise carrying out, after removal of said first pair of remaining service-layer portions, a second thermal treatment so as to form simultaneously the gate insulating layer and the field insulating layer, the first and second pairs of initial thickened portions (98b-98d, 100b-100d) forming, respectively, the gate-connecting thickened portions (70a, 70b) and the field-connecting thickened portions (72a, 72b).

3. The process according to claim 2, wherein said step of selectively removing portions of the service layer (84) include overetching part of the thick insulating layer (80b).

## Patentansprüche

1. Vertikale Halbleitervorrichtung, aufweisend:
- einen Halbleiterkörper (2) mit einer oberen Oberfläche (S_{b});
- einen Graben (22), der ausgehend von der oberen Oberfläche in dem Halbleiterkörper gebildet ist und Seitenwände (22a, 22b) und einen Boden aufweist;
- einen Gatebereich (14) aus leitfähigem Material, der sich innerhalb des Grabens erstreckt;
- einen Isolierbereich (60), der sich entlang von unteren Bereichen der Seitenwände des Grabens und auf dem Boden des Grabens erstreckt;
- eine Gate-Isolierschicht (52), die sich entlang von oberen Bereichen der Seitenwände des Grabens oben auf dem Isolierbereich sowie seitlich in Bezug auf den Gatebereich erstreckt;
- einen leitfähigen Bereich (24), der sich innerhalb des Grabens erstreckt, wobei ein oberer Bereich des leitfähigen Bereichs an der Oberseite sowie seitlich von dem Gatebereich umgeben ist und ein unterer Bereich des leitfähigen Bereichs am Boden sowie seitlich von dem Isolierbereich umgeben ist; und
- eine Feldisolierschicht (54), die zwischen dem Gatebereich und dem leitfähigen Bereich angeordnet ist, um den Gatebereich und den leitfähigen Bereich elektrisch voneinander zu trennen;
**dadurch gekennzeichnet, dass** die Feldisolierschicht mit dem Isolierbereich mittels Feldverbindungs-Verdickungsbereichen (72a, 72b) verbunden ist, die jeweils eine Dicke aufweisen, die mit zunehmender Tiefe zunimmt; und wobei die Gate-Isolierschicht (52) mit dem Isolierbereich (60) mittels Gateverbindungs-Verdickungsbereichen (70a, 70b) verbunden ist, die jeweils eine Dicke aufweisen, die mit zunehmender Tiefe zunimmt; und wobei die Seitenwände (22a, 22b) des Grabens (22) derart wellig ausgebildet sind, dass sich die Breite des Grabens in nicht monotoner Weise mit der Tiefe ändert, so dass sie an der oberen Oberfläche (S_{b}) einen ersten Wert annimmt, dann mit zunehmender Tiefe geringer wird, bis sie ein erstes relatives Minimum annimmt, dann wieder zunimmt, bis sie ein relatives Maximum auf einer Tiefe gleich höchstens der maximalen Tiefe des Gatebereichs (14) annimmt und dann bis zum Boden des Grabens monoton abnimmt; und wobei der leitfähige Bereich (24) entsprechende Seitenwände (24a, 24b) aufweist, die in einer derartigen Weise wellig ausgebildet sind, dass die Breite des leitfähigen Bereichs in nicht monotoner Weise mit der Tiefe varüert, so dass sie ausgehend von einer oberen Wand (24c) des leitfähigen Bereichs (24) zunimmt, bis sie ein relatives Maximum auf einer Tiefe zeigt, die zwischen der Tiefe der oberen Wand (24c) des leitfähigen Bereichs (24) und der maximalen Tiefe des Gatebereichs (14) liegt, sodann abnimmt, bis sie ein Minimum auf einer Tiefe annimmt, die nicht größer ist als die maximale Tiefe des Gatebereichs (14), und dann bis zum Boden des leitfähigen Bereichs (24) monoton zunimmt.

2. Verfahren zum Herstellen einer vertikalen Halbleitervorrichtung, das folgende Schritte aufweist:
- Bilden eines Halbleiterkörpers (2) mit einer oberen Oberfläche (S_{b});
- in dem Halbleiterkörper erfolgendes Bilden eines Grabens (22), der Seitenwände und einen Boden aufweist und sich von der oberen Oberfläche weg erstreckt;
- innerhalb des Grabens erfolgendes Bilden eines Gatebereichs (14) aus leitfähigem Material;
- entlang von unteren Bereichen der Seitenwände des Grabens und auf dem Boden des Grabens erfolgendes Bilden eines Isolierbereichs (60), wobei der Schritt des Bildens eines Isolierbereichs (60) das Bilden einer dicken Isolierschicht (80b) innerhalb des Grabens (22) beinhaltet;
- entlang von oberen Bereichen der Seitenwände des Grabens erfolgendes Bilden einer Gate-Isolierschicht (52), die sich oben auf dem Isolierbereich sowie seitlich in Bezug auf den Gatebereich erstreckt;
- innerhalb des Grabens erfolgendes Bilden eines leitfähigen Bereichs (24) mit Seitenwänden (24a, 24b), wobei ein oberer Bereich des leitfähigen Bereichs oben und seitlich von dem Gatebereich umgeben ist und ein unterer Bereich des leitfähigen Bereichs am Boden und seitlich von dem Isolierbereich umgeben ist, wobei der Schritt des Bildens eines leitfähigen Bereichs (24) des Bilden des leitfähigen Bereichs in einer derartigen Weise beinhaltet, dass sich dieser teilweise oben auf der dicken Isolierschicht erstreckt und eine erste Vertiefung (C₁) und eine zweite Vertiefung (C₂) innerhalb des Grabens gebildet werden, wobei der Boden der Vertiefungen jeweils von der dicken Isolierschicht begrenzt wird; und
- zwischen dem Gatebereich und dem leitfähigen Bereich erfolgendes Bilden einer Feldisolierschicht (54), die den Gatebereich und den leitfähigen Bereich elektrisch voneinander trennt;
**dadurch gekennzeichnet, dass** es ferner folgende Schritte aufweist:
- Verbinden der Feldisolierschicht (54) mit dem Isolierbereich (60) mittels Feldverbindungs-Verdickungsbereichen (72a, 72b), die jeweils eine Dicke aufweisen, die mit zunehmender Tiefe zunimmt;
- Verbinden der Gate-Isolierschicht (52) mit dem Isolierbereich (60) mittels Gateverbindungs-Verdickungsbereichen (70a, 70b) verbunden ist, die jeweils eine Dicke aufweisen, die mit steigender Tiefe zunimmt;
wobei das Verfahren ferner folgende Schritte aufweist:
- Beschichten der oberen Bereiche der Seitenwände (22a, 22b) des Grabens (22), der oberen Bereiche der Seitenwände des leitfähigen Bereichs und des jeweiligen Bodens der ersten und der zweiten Vertiefung (C₁, C₂) mit einer Serviceschicht (84) aus dielektrischem Material;
- auf den Bereichen der Serviceschicht, die die oberen Bereiche der Seitenwände des Grabens und die oberen Bereiche der Seitenwände des leitfähigen Bereichs bedecken, erfolgendes Bilden von entsprechenden Abstandselementen (90a-90d) aus nicht oxidierendem Material; und
- selektives Entfernen von Bereichen der Serviceschicht, die auf dem jeweiligen Boden der ersten und der zweiten Vertiefung angeordnet sind, um ein erstes Paar (84a-84b) und ein zweites Paar (84c-84d) von verbleibenden Serviceschicht-Bereichen zu bilden, wobei das erste und das zweite Paar von verbleibenden Serviceschicht-Bereichen die oberen Bereiche der Seitenwände des Grabens bzw. die oberen Bereiche der Seitenwände des leitfähigen Bereichs bedecken;
und wobei die Schritte des Verbindens der Gate-Isolierschicht (52) und der Feldisolierschicht (54) mit dem isolierenden Bereich (60) das nach dem Bilden der Abstandselemente und nach dem selektiven Entfernen von auf dem jeweiligen Boden der ersten und der zweiten Vertiefung angeordneten Bereichen der Serviceschicht erfolgende Ausführen einer ersten Wärmebehandlung in einer derartigen Weise beinhalten, dass das erste und das zweite Paar von verbleibenden Serviceschicht-Bereichen ein erstes Paar (98b-98d) bzw. ein zweites Paar (100b-110d) von verdickten Anfangsbereichen am Boden der ersten und der zweiten Vertiefung bilden;
wobei das Verfahren weiterhin folgende Schritte aufweist:
- Entfernen der Abstandselemente (90a-90d); und anschließendes
- Entfernen des ersten Paares (84a-84b) der verbleibenden Serviceschicht-Bereiche und gleichzeitiges Reduzieren der Dicke des zweiten Paares (84c-84d) von verbleibenden Serviceschicht-Bereichen:
und wobei der Schritt des Bildens einer Gate-Isolierschicht (52), der Schritt des Bildens einer Feldisolierschicht (54) sowie die Schritte des Verbindens der Gate-Isolierschicht und der Feldisolierschicht mit dem Isolierbereich (60) das nach dem Entfernen des ersten Paares von verbleibenden Serviceschicht-Bereichen erfolgende Ausführen einer zweiten Wärmebehandlung beinhalten, um gleichzeitig die Gate-Isolierschicht und die Feldisolierschicht zu bilden, wobei das erste und das zweite Paar der verdickten Anfangsbereiche (98b-98d, 100b-100d) die Gateverbindungs-Verdickungsbereiche (70a, 70b) bzw. die Feldverbindungs-Verdickungsbereiche (72a, 72b) bilden.

3. Verfahren nach Anspruch 2,
wobei der Schritt des selektiven Entfernens von Bereichen der Serviceschicht (84) das Überätzen eines Teils der dicken Isolierschicht (80b) beinhaltet.

## Revendications

1. Dispositif à semi-conducteurs vertical, comprenant :
- un corps semi-conducteur (2) ayant une surface supérieure (S_{b}) ;
- une tranchée (22) formée dans le corps semi-conducteur en commençant par la surface supérieure et comportant des parois latérales (22a, 22b) et un fond ;
- une région de grille (14) en un matériau conducteur, s'étendant dans la tranchée ;
- une région d'isolement (60) s'étendant le long des parties de fond des parois latérales de la tranchée et sur le fond de la tranchée ;
- une couche d'isolement de grille (52) s'étendant le long des parties supérieures des parois latérales de la tranchée sur la région d'isolement et latéralement par rapport à la région de grille ;
- une région conductrice (24) s'étendant dans la tranchée, une partie supérieure de la région conductrice étant entourée sur le dessus et latéralement par la région de grille, une partie inférieure de la région conductrice étant entourée dans le fond et latéralement par la région d'isolement ; et
- une couche d'isolement de champ (54) agencée entre la région de grille et la région conductrice de manière à séparer électriquement la région de grille et la région conductrice l'une de l'autre ;
**caractérisé en ce que** la couche d'isolement de champ est reliée à la région d'isolement au moyen de parties épaissies de liaison de champ (72a, 72b), chacune ayant une épaisseur qui augmente alors que la profondeur augmente ; et dans lequel la couche d'isolement de grille (52) est reliée à la région d'isolement (60) au moyen de parties épaissies de liaison de grille (70a, 70b), chacune ayant une épaisseur qui augmente alors que la profondeur augmente ; et dans lequel les parois latérales (22a, 22b) de la tranchée (22) sont ondulées de manière à ce que la largeur de la tranchée varie d'une manière non monotone avec la profondeur, atteignant de ce fait une première valeur au niveau de la surface supérieure (S_{b}), diminuant ensuite alors que la profondeur augmente jusqu'à ce qu'un premier minimum relatif soit atteint, augmentant ensuite de nouveau, jusqu'à ce qu'elle atteigne un maximum relatif à une profondeur égale au plus à la profondeur maximum de la région de grille (14), diminuant ensuite de manière monotone jusqu'au fond de la tranchée ; et dans lequel la région conductrice (24) comporte des parois latérales (24a, 24b) correspondantes, qui sont ondulées, de manière à ce que la largeur de la région conductrice varie d'une manière non monotone avec la profondeur, augmentant de ce fait, en commençant à partir d'une paroi supérieure (24c) de la région conductrice (24), jusqu'à présenter un maximum relatif, à une profondeur comprise entre la profondeur de la paroi supérieure (24c) de la région conductrice (24) et la profondeur maximum de la région de grille (14), diminuant ensuite jusqu'à atteindre un minimum à une profondeur inférieure ou égale à la profondeur maximum de la région de grille (14), et augmentant ensuite de manière monotone jusqu'au fond de la région conductrice (24).

2. Processus pour fabriquer un dispositif à semi-conducteurs vertical, comprenant les étapes :
- de formation d'un corps semi-conducteur (2) comportant une surface supérieure (S_{b}) ;
- de formation, dans le corps semi-conducteur, d'une tranchée (22) comportant des parois latérales et un fond et s'étendant à partir de la surface supérieure
- de formation, dans la tranchée, d'une région de grille (14) en un matériau conducteur ;
- de formation, le long des parties inférieures des parois latérales de la tranchée et sur le fond de la tranchée, d'une région d'isolement (60), ladite étape de formation d'une région d'isolement (60) comprenant la formation d'une couche d'isolement épaisse (80b) dans la tranchée (22) ;
- de formation, le long des parties supérieures des parois latérales de la tranchée, d'une couche d'isolement de grille (52), une couche d'isolement de grille s'étendant sur la région d'isolement et latéralement par rapport à la région de grille ;
- de formation, dans la tranchée, d'une région conductrice (24) comportant des parois latérales (24a, 24b), une partie supérieure de la région conductrice étant entourée sur le dessus et latéralement par la région de grille, une partie inférieure de la région conductrice étant entourée dans le fond et latéralement par la région d'isolement, ladite étape de formation d'une région conductrice (24) comprenant la formation de la région conductrice de manière à ce qu'elle s'étende en partie sur la couche d'isolement épaisse, définissant une première cavité (C₁) et une deuxième cavité (C₂) dans la tranchée, les fonds desdites cavités étant délimités par la couche d'isolement épaisse ; et
- de formation, entre la région de grille et la région conductrice, d'une couche d'isolement de champ (54) qui sépare électriquement la région de grille et la région conductrice l'une de l'autre ; **caractérisé en ce qu'**il comprend en outre les étapes :
- de liaison de la couche d'isolement de champ (54) à la région d'isolement (60) au moyen de parties épaissies de liaison de champ (72a, 72b), chacune ayant une épaisseur qui augmente alors que la profondeur augmente ;
- de liaison de la couche d'isolement de grille (52) à la région d'isolement au moyen de parties épaissies de liaison de grille (70a, 70b), chacune ayant une épaisseur qui augmente alors que la profondeur augmente ;
ledit processus comprenant en outre les étapes :
- de revêtement, avec une couche de service (84) en un matériau diélectrique, des parties supérieures des parois latérales (22a, 22b) de la tranchée (22), des parties supérieures des parois latérales de la région conductrice et des fonds des première et deuxième cavités (C₁, C₂) ;
- de formation, sur les parties de la couche de service qui recouvrent les parties supérieures des parois latérales de la tranchée et les parties supérieures des parois latérales de la région conductrice, d'éléments d'espacement (90a-90d) correspondants en un matériau non oxydant ; et
- de retrait de manière sélective de parties de la couche de service agencées sur les fonds des première et deuxième cavités de manière à définir une première paire (84a-84b) et une deuxième paire (84c-84d) de parties de couche de service restantes, lesdites première et deuxième paires de parties de couche de service restantes recouvrant, respectivement, les parties supérieures des parois latérales de la tranchée et les parties supérieures des parois latérales de la région conductrice ;
et dans lequel les étapes de liaison de la couche d'isolement de grille (52) et de la couche d'isolement de champ (54) à la région d'isolement (60) comprennent l'exécution, après la formation des éléments d'espacement et après le retrait sélectif de parties de la couche de service agencées sur les fonds des première et deuxième cavités, d'un premier traitement thermique, de manière à ce que les première et deuxième paires de parties de couche de service restantes forment, respectivement, une première paire (98b-98d) et une deuxième paire (100b-100d) de parties épaissies initiales sur les fonds des première et deuxième cavités ;
ledit processus comprenant en outre les étapes :
- de retrait des éléments d'espacement (90a-90d) ; et ensuite
- de retrait de ladite première paire (84a-84b) de parties de couche de service restantes et de réduction simultanément de l'épaisseur de ladite deuxième paire (84c-84d) de parties de couche de service restantes ;
et dans lequel l'étape de formation d'une couche d'isolement de grille (52), l'étape de formation d'une couche d'isolement de champ (54) et les étapes de liaison de la couche d'isolement de grille et de la couche d'isolement de champ à la région d'isolement (60) comprennent l'exécution, après le retrait de ladite première paire de parties de couche de service restantes, d'un deuxième traitement thermique de manière à former simultanément la couche d'isolement de grille et la couche d'isolement de champ, les première et deuxième paires de parties épaissies initiales (98b-98d, 100b-100d) formant, respectivement, les parties épaissies de liaison de grille (70a, 70b) et les parties épaissies de liaison de champ (72a, 72b).

3. Processus selon la revendication 2, dans lequel ladite étape de retrait sélectif de parties de la couche de service (84) comprend la surgravure d'une partie de la couche d'isolement épaisse (80b).
